Europäisches Patentamt

European Patent Office

Office européen des brevets

(11) Publication number: **0 389 694**
**A1**

## EUROPEAN PATENT APPLICATION

(21) Application number: **89203126.1**

(22) Date of filing: **08.12.89**

(51) Int. Cl.⁵: **H01L 21/321**

The title of the invention has been amended (Guidelines for Examination in the EPO, A-III, 7.3).

(30) Priority: **14.12.88 GB 8829161**

(43) Date of publication of application:
**03.10.90 Bulletin 90/40**

(84) Designated Contracting States:
**DE FR GB IT NL**

(71) Applicant: **PHILIPS ELECTRONIC AND ASSOCIATED INDUSTRIES LIMITED**
**Philips House 188 Tottenham Court Road**
**London W1P 9LE(GB)**

(84) **GB**

Applicant: **N.V. Philips' Gloeilampenfabrieken**
**Groenewoudseweg 1**
**NL-5621 BA Eindhoven(NL)**

(84) **DE FR IT NL**

(72) Inventor: **McCulloch, David James**
**C/O PHILIPS RESEARCH LABORATORIES**
**Redhill Surrey RH1 5HA(GB)**

(74) Representative: **Stevens, Brian Thomas et al**
**PHILIPS ELECTRONICS Patents and Trade Marks Department Philips House 188 Tottenham Court Road**
**London W1P 9LE(GB)**

(54) Semiconductor device manufacture with laser-induced chemical etching.

(57) In the manufacture of a semiconductor device, both a crystalline area (1b) and an amorphous area (1a) of a semiconductor layer are exposed to a laser beam (2) or other radiant energy of ultraviolet wavelength in a chemical reactive ambient (3), e.g. of $CF_2Br_2$. The ultraviolet radiant energy (2) is weakly absorbed in the gas ambient (3) to produce chemically reactive radicals and is strongly absorbed in the semiconductor layer (1a,1b) to heat directly the amorphous area (1a) more strongly than the crystalline area (1b). In this manner the amorphous area (1a) is chemically etched preferentially with respect of the crystalline area (1b) which may be used to form an emitter region or other active area of the semiconductor device. Preferably the amorphous area (1a) is formed on an insulating layer (4 and 5) with the crystalline area (1b) in a window on a monocrystalline substrate (6). The insulating layer (4 and 5) provides a thermal barrier below the heated amorphous area (1a) of the semiconductor layer, and because the insulating layer is not heated by the ultraviolet energy (2) it protects the underlying substrate (6) against degradation by heating.

Fig.4.

## SEMICONDUCTOR DEVICE MANUFACTURE

This invention relates to methods of manufacturing semiconductor devices in which material is chemically etched away from a semiconductor layer by exposure to a laser beam or other radiant energy, in a chemically reactive ambient. Particularly but not exclusively, such a method may be such as to manufacture a device having active regions provided in one or more crystalline-silicon areas formed by etching other areas in this manner.

Laser-induced chemical etching of silicon and other semiconductor materials, especially in halogen-containing gas ambients is described in Section 8.2 on pages 173 to 184 of the book entitled "Chemical Processing with Lasers" by Dieter Baeuerle, published in 1986 by Springer-Verlag Berlin, Heidelberg, New York, London, in the Springer series in Materials Science. It is recognised that, in general terms, chemical etching involves physical or chemical sorption of the ambient reactants, reactions between adsorbed species and atoms or molecules of the material to be etched and desorption of product molecules. Laser radiation or other radiant energy can influence any or all of these processes by photothermal and/or photochemical excitation of the ambient molecules, adsorbate-surface complexes and/or the material exposed to the radiant energy. Table 8.1 on pages 163 to 168 summarizes a variety of laser-induced chemical etching systems which have been used with silicon and other semiconductor materials. Carbon dioxide and YAG lasers at infrared wavelengths and excimer lasers at ultraviolet wavelengths have been used in different etching systems.

It is known to use such laser-induced chemical-etching systems to etch selectively a semiconductor material (e.g. silicon) in the presence of a non-semiconductor material (e.g. silicon dioxide or silicon nitride) or vice versa, and to etch locally an area of a semiconductor layer by localising the exposure of the layer to the laser beam. It has also been observed that photogeneration of electron-hole pairs in the semiconductor material by an ultraviolet laser beam can be a significant mechanism in determining the etching rate, and that the surface reaction rate of halogen radicals is enhanced for increased electron densities in the semiconductor material. It appears to be this mechanism which permits n type material to be etched away faster than p type material, and highly-doped material with many electrons in the conduction band to be etched away faster than low-doped material.

It is also known from published Japanese patent application (Kokai) JP-A-59.186328 to etch selectively a thin film of semiconductor material in a HCl gas ambient by absorption of infrared energy from a $CO_2$ laser in a silicon dioxide insulating layer underlying an area of the silicon film. This laser energy is not absorbed to any significant extent in the silicon film or the HCl ambient. The silicon dioxide layer (heated by absorption of the infrared energy) heats the overlying area of the silicon film which is polycrystalline, and this overlying polycrystalline area etches away in the HCl ambient, preferentially with respect to the adjacent (monocrystalline) area of the silicon film on the substrate area not covered by the silicon dioxide layer. However a disadvantage of this process is the requirement to heat strongly the insulating layer with the laser beam because this layer heats also the substrate area with which it is in contact. This heating may degrade the semiconductor properties at the interface of the substrate and insulating layer and may degrade any semiconductor device structures already formed in, for example, the substrate.

The present invention permits preferential etching of areas of exposed semiconductor material to provide a desired pattern by absorption of the radiant energy in the material itself and also partly in the gas ambient, and permits amorphous material to be etched away in a self-aligned manner with respect to an area of crystalline semiconductor material without requiring strong heating of any underlying insulating layer by absorption of the radiant energy in the insulating layer.

According to the present invention, there is provided a method of manufacturing a semiconductor device in which material is chemically etched away from a semiconductor layer by exposing the semiconductor layer to radiant energy in a chemically-reactive gas ambient, wherein the semiconductor layer has a first area of crystalline semiconductor material beside a second area of less crystalline material and both areas are exposed to the radiant energy in the chemically-reactive ambient to etch away the second area preferentially with respect to the first area, characterised in that the second area is of substantially amorphous material and in that the radiant energy is of at least one ultraviolet wavelength, the ultraviolet radiant energy being weakly absorbed in the gas ambient to produce chemically reactive radicals in the ambient and being strongly absorbed in the semiconductor layer to heat directly the amorphous material of the second area more strongly than the crystalline material of the first area thereby chemically etching away the amorphous material with the chemically reactive radicals.

2

This invention is based on a recognition and discovery by the present inventor that (without needing to heat any underlying insulating layer and without needing to localise the exposure to only the area to be etched away) local etching of an area of a semiconductor layer can be achieved selectively to leave a crystalline area by choosing the wavelength of the radiant energy to be in the ultraviolet range such that this area in an amorphous form strongly absorbs the radiant energy so as to be heated thereby. By directly heating the semiconductor layer in this manner and by using the radiant energy to produce also the chemically reactive radicals in the ambient, the temperature of an underlying substrate area during the etching treatment can be significantly less than for $CO_2$ laser heating via a silicon dioxide layer. The amorphous area is heated more strongly than the crystalline material even though both are equally exposed to the radiant energy. In part this stronger heating seems to be due to an enhanced absorption of the ultraviolet in the amorphous material, although the lower thermal conductivity of the amorphous material seems to play a major role. It is found that the degree to which this manner of etching the amorphous area predominates over any etching of the crystalline area can provide very good selectivity in the etching, even though photogeneration of electron-hole pairs in the semiconductor material is expected to render the crystalline area more electrically conductive than the amorphous area.

Depending on the device to be manufactured, the semiconductor layer may be a surface-adjacent portion of a semiconductor substrate, or it may be a layer of semiconductor material deposited on the surface of a substrate which may be of semiconductor material or of insulating material or of conductive material or of a combination thereof. The semiconductor layer may be continuous in its structure, or it may have discontinuities therein (for example where it is deposited over a step at the surface of a substrate). The crystalline area or areas may be formed by local crystallisation of amorphous material, or the amorphous area or areas may be formed by local damage (e.g. by bombardment) of crystalline material. Where the layer is formed by growth on a substrate surface which is partly crystalline and partly amorphous, the deposition conditions may be so chosen that the semiconductor material grows in crystalline form on a crystalline substrate area whereas that deposited on another substrate area grows in amorphous form. Alternatively, the crystalline area of the layer may be formed by an annealing treatment after deposition.

In order to enhance the heating of the amorphous material by the radiant energy, the amorphous material may be formed on a substrate area which is thermally insulating and/or reflective of the radiant energy at least to a greater extent than the substrate area on which the crystalline material is formed. This can be especially beneficial when etching thin layers, and a thermally-insulating area below the heated amorphous material can also provide a thermal barrier protecting the underlying substrate part against heating. Thus, for example, the heated amorphous material may be present on an insulating layer comprising silicon nitride which forms a reflective interface with the amorphous material as well as having good thermally insulating properties. This further reduces heating of the underlying part of the substrate by the ultraviolet radiant energy.

These different substrate areas may also have different crystalline properties appropriate to the different areas of the deposited layer. In a particularly advantageous arrangement, there is formed on a crystalline substrate an insulating layer having an opening which exposes an area of the substrate, and semiconductor material is deposited to form the semiconductor layer on the insulating layer and on the substrate at the opening. This structure permits the semiconductor material to be substantially amorphous on the insulating layer and crystalline on the crystalline substrate in the opening. In this arrangement the semiconductor layer can be removed throughout its thickness from the surface of the insulating layer in the etching step to expose the insulating layer and to leave the crystalline semiconductor material in the opening of the insulating layer. This resulting structure may then be used in different ways depending on the structure required for the device being manufactured.

High intensity ultraviolet lamps may be used as the source of radiant energy for the etching step. However, it is particularly advantageous to use a laser (for example of the excimer type) in order to obtain a collimated and more intense beam of the ultraviolet radiant energy. Furthermore the wavelength from a laser can be chosen in relation to the materials in the layer and in its ambient more easily than with lamps so as to control the absorption of the radiant energy with respect to the different materials to achieve desired results. Thus, in particular gas ambients, the chemically reactive radicals used for etching can be formed by excitation and dissociation of the ambient molecules with an appropriate laser wavelength.

These and other features in accordance with the invention are illustrated, by way of example, in a few embodiments of the invention now to be described with reference to the accompanying diagrammatic drawings, in which:

Figures 1,2,4 and 5 are cross-sectional views of part of a body of a semiconductor device at different stages in its manufacture by a method in accordance with the invention;

Figure 3 is a schematic representation of one example of equipment for effecting the laser-induced chemical-etching step illustrated in Figure 4, and

Figures 6 and 7 are cross-sectional views of parts of different bodies of semiconductor devices during their manufacture by two different methods in accordance with the invention.

It should be noted that the Figures are diagrammatic and not drawn to scale. Particularly in the direction of thickness in the cross-sectional views, the proportions of various features have been exaggerated or diminished in size for the sake of convenience and clarity in the drawings. The reference signs used in one embodiment are also used for corresponding or similar parts in the other embodiments.

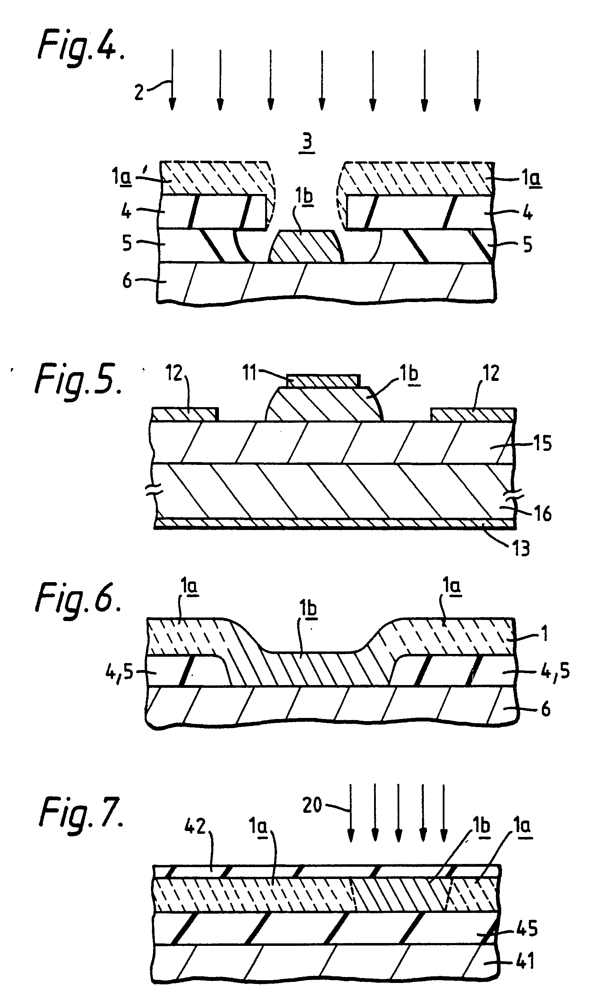

Figure 4 illustrates a stage in the manufacture of a semiconductor device in which material 1a is etched away from a semiconductor layer 1 by exposing the semiconductor layer 1 to radiant energy 2 in a chemically reactive ambient 3. In accordance with the present invention, the semiconductor layer 1 has been formed with at least one area of crystalline material 1b beside at least one area of substantially amorphous material 1a, and both the crystalline and amorphous material areas are exposed to the radiant energy 2 which is of at least one ultraviolet wavelength. The ultraviolet radiant energy 2 is weakly absorbed in the gas ambient 3 to produce chemically reactive radicals in the ambient 3 and is strongly absorbed in the semiconductor layer 1 to heat directly the amorphous material 1a more strongly than the crystalline material; thereby the amorphous material 1a is chemically etched away with the reactive radicals in the ambient 3, preferentially with respect to the crystalline material 1b.

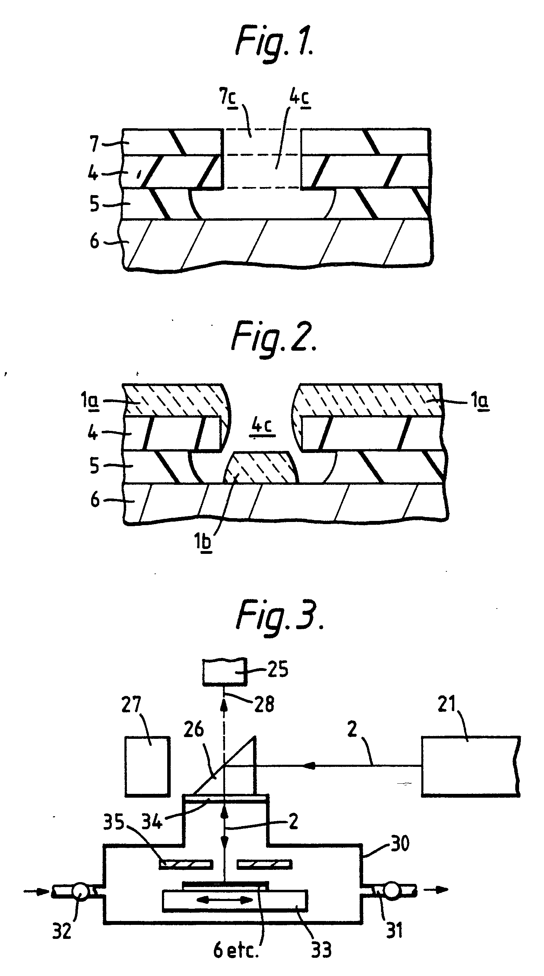

In the structure illustrated in Figure 4 the layer 1 has discontinuities at the edge of a window in an insulating layer 4 and 5 on a substrate 6. The amorphous material 1a is present on the surface of the insulating layer 4 and 5, and the crystalline material 1b is present at the lower level of the substrate surface in the window. By etching in this manner, the amorphous material 1a may be removed entirely from the surface of the insulating layer 4 and 5. Reference will now be made to Figures 1 and 2 to describe the fabrication of a particular form of this structure.

A semiconductor device body at the stage of Figure 1 may be formed by, for example, a monocrystalline silicon substrate 6. A continuous layer 5 of, for example, silicon dioxide may be provided in known manner (for example by chemical vapour deposition) on a surface of the substrate 6. A continuous layer 4 of, for example, silicon nitride may then be deposited in known manner on the surface of the silicon dioxide layer 5. The thicknesses of layers 4 and 5 are chosen according to the function they serve. One or both of the layers 4 and 5 may be retained in the manufactured device or removed after the Figure 4 stage. The silicon dioxide layer 5 may serve to passivate and to protect part of the substrate surface. At least in the stage of Figure 4, the silicon nitride layer 4 serves to reflect any of the ultraviolet radiant energy 2 not absorbed by the layer 1 and so reduces heating of the underlying part of the silicon substrate 6, particularly towards the end of the etching step. Some absorption of the ultraviolet in the silicon nitride 4 also occurs when the overlying amorphous material 1a has been removed. Its thickness may be, for example, about 100 nm (nanometres). A typical total thickness for the layers 4 and 5 is for example 500 nm.

A layer of photoresist 7 is then coated onto the silicon nitride layer 4 and is selectively exposed to form at least one etchant window 7c through which the silicon nitride layer is substantially etched in known manner. Through the resulting window 4c in the silicon nitride layer 4, the silicon dioxide layer 5 is etched, and this etching may be continued until the resulting window in the silicon dioxide layer 5 is overhung by the edge of the window 4c in the silicon nitride layer 4.

As illustrated in Figure 2, the surface of the silicon nitride layer 4 and the substrate surface at the window 4c are then coated by evaporation in known manner with amorphous silicon to form the layer 1 at a deposition temperature in the range of, for example, 150 to 300°C (degrees Celsius). The layer 1 may have a thickness in the range of, for example, 50 to 250 nm. The resulting layer 1 is discontinuous at the edge of the window 4c in the silicon nitride layer 4 due to the window overhang and the smaller thickness of the silicon layer 1. All areas 1a and 1b of the layer 1 are amorphous when deposited in Figure 2.

The silicon layer 1 is then annealed, for example by heating the body at 650°C (degrees Celsius) for 15 minutes, to crystallise the area(s) 1b of amorphous material in contact with the monocrystalline silicon substrate 6 at the window(s) 4c. In this situation the material 1b can become monocrystalline. The material 1a on the silicon nitride layer 4 remains at least predominantly amorphous. However it should be noted that it may not be totally amorphous, particularly when the deposition and anneal temperatures are high and long anneal times are used. Thus, small crystallites having an average grain size of about 10nm or less may be present, embedded in the amorphous material. For the purposes of the present invention, such embedded crystallites are acceptable, because the material 1a still retains a significantly lower thermal conductivity than the crystallised parts 1b, and it is still heated much more strongly by the radiant energy 2 than is the crystalline material 1b.

There are several advantages in forming a discontinuous layer 1. It permits a clear distinction between the amorphous material 1a and the crystallised material 1b even when the crystallisation has been achieved by simply heating the whole body. The gap between the crystallised part 1b and the window edge of the insulating layer(s) 4 and 5 also avoids the straining of the crystal lattice of the part 1b by the insulating layers 4 and 5. The avoidance of such lattice strain can be important in some but not all types of semiconductor device.

Figure 3 illustrates an example of known equipment which can be used for etching the structure of Figure 4 and other device structures in accordance with the invention. The etching is carried out in a reaction chamber 30 having an outlet 31 connected to a pump for creating a partial vacuum within the chamber 30. The desired etching gas composition is supplied to the chamber 30 via an inlet 32. The device body 6 etc is mounted on a work-table 33 which can be moved in the work area and exposed to an ultraviolet laser beam 2 via a window 34 of the chamber. Reference 21 indicates the laser. The system may also comprise a microscope 25 or other means (which may be coupled to a television monitor) for observing the body 6 etc on the work table 33. The laser beam 2 may be directed to the body 6 etc via a quartz prism 26 which is moveable out of the path of the laser beam so as to permit a light path 28 from the work area to the observation means 25. The prism 26 may also be moveable in the path of the beam 2 so as to direct the beam 2 to particular areas of the body 6 etc. The beam 2 is perpendicularly incident on the body 6 etc to maximise its heating effect. A light trap 27 for the laser beam is also included in this system. All these components of the system may be of known form. The applicants have found that a laser 21 of the excimer type gives very uniform and controllable exposures for large area processing at desired wavelengths in the ultraviolet range. The path of the laser beam 2 is fixed by the optics of the system of Figure 3, and the body 6 etc is moved laterally in both X and Y directions on the table 23 so as to expose large areas as desired to the beam 2. A mask 35 may be in a fixed position in the chamber 30 for exposing a selected area of the body 6 etc moved thereunder, while masking other areas.

Various combinations of gas composition and laser wavelength may be used to etch away the amorphous semiconductor material 1a. For amorphous silicon material 1a, the following combinations may, for example, be used:
with an ArF laser wavelength of 193nm the gas may be $CF_2Br_2$, $CF_2Cl_2$ or for example $NF_3$;
with a KrF laser wavelength of 248nm the gas may be, for example, $CF_2Br_2$.

These combinations have been found to provide good selectivity in etching the amorphous silicon material 1a faster than the crystalline silicon material 1b. Quite low fluence beams, e.g. of about 150mJ.cm$^{-2}$ per pulse have been used with pulse rates in the range of, for example, 10 to 100Hz. The laser wavelengths at which the etching occurs coincides with the wavelength at which weak but significant absorption of the laser light occurs in the gas, and so it is thought that the gas produces chemically reactive radicals by the action of the laser beam 2 in exciting and dissociating the ambient gas molecules. The degree of absorption depends on the gas pressure. Increasing the gas pressure increases the absorption of the beam in the ambient 3 and so reduces the pulse energy density incident on the layer 1. Gas pressures in the range of 2 to 20 Torr (about 267 to 2667 Pa) have been used.

With 50nm thick layers 1, ArF light 2 induces chemical etching of the amorphous silicon 1a regardless of whether the gas is $CF_2Br_2$ or $CF_2Cl_2$. However, for 200nm thick layers 1, it was found that only KrF light onto $CF_2Br_2$ etches at low pulse energy. This suggests that the beam-heating of the layer 1 which is greater for thinner layers is more important when the gas absorption is low. In the extreme case of XeF light (a wavelength of 352nm which is not absorbed to any significant extent by either of these two gases), etching was only found to occur in the presence of $CF_2Br_2$ with high pulse fluences (about 300mJ.cm$^{-2}$ per pulse) which are so high that they may cause gross structural changes in the layer 1 due to the beam-heating Even when the laser wavelength and gas composition are such as to produce significant absorption, a threshold in pulse fluence incident on the layer 1 has been observed (e.g. about 130 mJ.cm$^{-2}$ per pulse with a KrF excimer laser 21 and a $CF_2Br_2$ ambient at a pressure of 2000 Pa) below which no significant etching of the amorphous material 1a occurs. This is a further indication of the importance of beam-heating to the etching process. However it should be noted that this beam-heating in accordance with the present invention is a direct heating of the semiconductor material 1a by absorption of the ultraviolet beam 2 in the semiconductor material 1, so that no significant heating occurs of the interface between the silicon dioxide layer 5 and the silicon substrate 6.

The excimer laser 21 can be operated at such a slow pulse rate that each laser pulse can be considered separately as single shots in its energy input to the exposed surface of the layer 1. It is found that by increasing the pulse rate from 10Hz to 40Hz the etching rate is increased by about 40%. This is probably due to a cumulative heating effect. The thermal conductivity of the monocrystalline silicon material 1b is much greater than that of the amorphous material 1a, for example about 2 orders of magnitude greater at room temperature and still an order of magnitude greater at 800K. Thus the pulse energy input to the crystalline material 1b is dissipated while that to the amorphous material 1a strongly heats its surface. The heating of the amorphous material 1a is further enhanced by the presence of the underlying thermally and electrically insulating layer 4 and 5, whereas the monocrystalline silicon substrate 6 provides a better thermal conduction path under the monocrystalline material 1b. Furthermore an advantage of using silicon nitride on silicon dioxide for the insulating layer 4 and 5 is that reflection can occur at the interfaces of layers 1a, 4 and 4,5, and the silicon nitride absorbs ultraviolet light better than silicon dioxide. When the amorphous silicon material 1a is present on the silicon nitride layer 4, this material 1a strongly absorbs the ultraviolet beam 2 so that very little ultraviolet radiation reaches the layer structure 4,5 and the underlying silicon substrate 6. However, when most of the amorphous material 1a has been etched away so that little or none remains to absorb the ultraviolet beam 2, the reflection and some absorption due to the inclusion of the silicon nitride 4 prevents excessive absorption of the beam 2 in the underlying silicon substrate 6. There is no significant heating of the interface between the silicon dioxide layer 5 and the silicon substrate 6.

Calculations indicate that the exposure to a KrF ultraviolet beam 2 of $150mJ.cm^{-2}$ per pulse in the Figure 4 arrangement results in surface temperatures approaching about 1000°C (degrees Celsius) for the amorphous material 1a and less than 250 to 300°C for the monocrystalline material 1b. As a result of this heating with the reactive radicals in the ambient 3, the amorphous semiconductor material 1a is chemically etched at a much faster rate than the monocrystalline material 1b in the window of the insulating layer 4 and 5. Under the conditions given, the etching rate of the amorphous silicon 1a is about 10pm (picometres) per pulse, whereas that of the crystalline silicon 1b is about 0.7pm per pulse. A 50nm thick layer of amorphous silicon material 1a can be removed in about 8 minutes with a pulse rate of 10Hz, whereas it is removed in less than 1 minute with a 100Hz rate. During this time less than 10% of the thickness of the monocrystalline silicon material 1b is removed. There is no discernible etching of silicon nitride (or of any exposed silicon dioxide). The selectivity of etching the amorphous silicon 1a with respect to the crystalline silicon 1b decreases slightly as the pulse energy increases towards $250mJ.cm^{-2}$ and increases as it approaches $130mJ.cm^{-2}$ (just before the threshold).

It is thought that a photon dissociation mechanism is responsible for producing the reactive radicals at least in the case of $CF_2X_2$ (where R is Br or Cl), and that the following process is involved in etching:

(a) absorption of photons by $CF_2X_2$ followed by dissociation of the molecule to release one of the X atoms and so to generate $CF_2X$ radicals.

(b) the $CF_2X$ radicals generated close to the hot amorphous silicon 1a are adsorbed before recombination in the gas phase can occur.

(c) the adsorbed radicals thermally dissociate and $SiF_4$ forms which then desorbs from the hot area 1a.

For some semiconductor devices it may be desirable to keep both insulating layers 4 and 5 or at least part of the silicon dioxide layer 5 around the window. Figure 5, however, illustrates a device structure in which both of the insulating layers 4 and 5 are etched away at least from around the window after the stage of Figure 4, and metal electrode layers 11 to 13 are provided to form separate connections to the crystalline silicon area 1b and to layers 15 and 16 of the silicon substrate 6. The area 1b may be, for example, an emitter region of a transistor of which the layer 15 forms the base region and the layer 16 forms the collector region. The conductivity-type determining doping of the layers 15 and 16 is carried out before the stage illustrated in Figure 1. The conductivity-type determining doping or dopings of the area 1b may be effected during the deposition of the silicon layer 1, and/or one or more such dopings may be effected after deposition at the Figure 2 stage (for example, by dopant ion implantation either before or after crystallization of the area 1b). The transistor of Figure 5 may be an n-p-n or p-n-p bipolar transistor, or it may be, for example, a hot-electron transistor having n type emitter, base and collector regions 1b, 15 and 16 respectively with depleted barrier layers containing p type dopant between the n type regions 1b and 15 and between the n type regions 15 and 6. The area 1b may comprise a stack of regions of different doping or different doping concentrations.

Figure 6 illustrates an arrangement for another semiconductor device, in which the insulation layer 4,5 does not have an overhung window and need not be a double layer as in Figures 1 and 2. In this case, the deposited silicon forms a continuous layer 1 on the insulating layer 4,5 and on the monocrystalline substrate 6 at the window. The area 1b in the window is rendered crystalline, for example by annealing the structure after deposition, whereas the area 1a on the insulating layer 4,5 remains amorphous. Thereafter, ultra-violet laser-induced chemical etching is carried out, for example in the equipment of Figure 3 and in a manner similar to that of Figure 4, to remove the amorphous material 1a from the insulating layer 4,5. The crystalline area 1b is retained in the window of the layer 4,5 to form an active region of the device. This area 1b may provide, for example, a transistor base region which is laterally bounded by the insulating layer 4,5 and in which an emitter region is subsequently provided locally.

Figure 7 illustrates another modification for the manufacture of another device by a method in accordance with the invention. In this case, the formation of a crystalline area of the layer 1 is not determined by the nature of the substrate. Thus, the semiconductor layer 1 may be deposited on an insulating layer 45 on a substrate 41. The whole of the layer 1 on the layer 45 is amorphous as a result of its deposition. A part 1b of the layer 1 is rendered crystalline by locally annealing it in known manner with a finely-focussed laser beam 20. The annealed part 1b in this case is normally not entirely monocrystalline but is usually polycrystalline with large monocrystalline grains. The remainder 1a of the layer 1 remains amorphous. An infrared beam 20 of a $CO_2$ laser may be used for this purpose, and the surface of the silicon layer 1 may be protected during this local annealing treatment by an encapsulating layer 42, for example of silicon nitride. After removing the encapsulating layer 42 (if present), the layer 1 is exposed to an ultraviolet laser-induced chemical etching process (for example in the equipment of Figure 3 and in a manner similar to that of Figure 4) to remove the amorphous material 1a and leave the crystalline material 1b.

From reading the present disclosure, other modifications will be apparent to persons skilled in the art. Thus, for example the deposition and etching steps may be repeated to form stacked-layer structures. Other modifications may involve other features which are already known in laser-induced processing systems and equipment and in the manufacture of semiconductor devices and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention. The applicants hereby give notice that new claims may be formulated to such features and/or combinations of such features during the prosecution of the present application or of any further application derived therefrom.

**Claims**

1. A method of manufacturing a semiconductor device in which material is chemically etched away from a semiconductor layer by exposing the semiconductor layer to radiant energy in a chemically-reactive gas ambient, wherein the semiconductor layer has a first area of crystalline semiconductor material beside a second area of less crystalline material and both areas are exposed to the radiant energy in the chemically-reactive ambient to etch away the second area preferentially with respect to the first area, characterised in that the second area is of substantially amorphous material and in that the radiant energy is of at least one ultraviolet wavelength, the ultraviolet radiant energy being weakly absorbed in the gas ambient to produce chemically reactive radicals in the ambient and being strongly absorbed in the semiconductor layer to heat directly the amorphous material of the second area more strongly than the crystalline material of the first area thereby chemically etching away the amorphous material with the chemically reactive radicals.

2. A method as claimed in Claim 1, further characterised in that there is formed on a crystalline substrate an insulating layer having an opening which exposes an area of the substrate, and that semiconductor material is deposited to form the semiconductor layer on the insulating layer and on the substrate at the opening, the semiconductor material being substantially amorphous on the insulating layer and crystalline on the crystalline substrate in the opening.

3. A method as claimed in Claim 2, further characterised in that the insulating layer comprises silicon nitride which reduces heating of the underlying part of the substrate by the ultraviolet radiant energy.

4. A method as claimed in Claim 2 or Claim 3, further characterised in that the semiconductor layer is removed throughout its thickness from the surface of the insulating layer in step (b) to expose the insulating layer and to leave the crystalline semiconductor material in the opening of the insulating layer.

5. A method as claimed in anyone of Claims 2 to 4, further characterised in that the semiconductor material in the opening is rendered crystalline on the crystalline substrate by annealing the semiconductor layer after deposition.

6. A method as claimed in any one of the preceding claims, further characterised in that the semiconductor material comprises silicon, and the reactive ambient comprises $CF_2Br_2$ which produces chemically reactive radicals by the action of the ultraviolet radiant energy.

7. A method as claimed in any one of the preceding claims, further characterised in that the ultraviolet radiant energy is in the form of a laser beam.

8. A method as claimed in Claim 7, further characterised in that the laser beam is generated by an excimer laser.

## Fig. 1.

## Fig. 2.

## Fig. 3.

Fig.4.

2

3

1a

4

5

6

1b

1a

4

5

Fig.5.

12

11

1b

12

15

16

13

Fig.6.

1a

1b

1a

1

4,5

4,5

6

Fig.7.

42

1a

20

1b

1a

45

41

2-II-PHB 33515

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | PATENT ABSTRACTS OF JAPAN, vol. 5, no. 197 (E-86), 12th September 1981; & JP-A-56 116 626 (SEIICHI) * Whole document * | 1,5,6 | H 01 L 21/321 |
| A | PROCEEDINGS ON THE 4th SYMPOSIUM ON DRY PROCESSES, Tokyo 1982, Institution of electrical engeneers (Publisher) Tokyo, JP, pages 6-10; H. OKANO et al.: "Phosphorous doped poly-Si etching employing Cl2: Effects of subsrate temperature and photo irradiation" * Whole document * | 1-6,8 | |
| A | EXTENDED ABSTRACTS OF THE 20th (1988 International) CONFERENCE ON SOLID STATE DEVICES AND MATERIALS, vol. 20, 1988, pages 73-76; J. TAKAHASHI et al.: "Reaction mechanisms with synchrotron radiation-stimulated etching of Si and SiO2 * Abstract; table 1 * | 1 | |
| D,A | PATENT ABSTRACTS OF JAPAN, vol. 9, no. 47 (E-299), 23rd October 1984; & JP-A-59 186 328 (SONY) * Whole document * | 1-8 | TECHNICAL FIELDS SEARCHED (Int. Cl.5) H 01 L |

The present search report has been drawn up for all claims

| Place of search | Date of completion of the search | Examiner |
|---|---|---|
| THE HAGUE | 26-03-1990 | GORI P. |

EPO FORM 1503 03.82 (P0401)